(19) Europäisches Patentamt
European Patent Office
Office européen des brevets

(11) EP 1 380 107 B1

(12) **EUROPEAN PATENT SPECIFICATION**

(45) Date of publication and mention of the grant of the patent:
**19.01.2005 Bulletin 2005/03**

(21) Application number: **02707931.8**

(22) Date of filing: **28.02.2002**

(51) Int Cl.[7]: **H03H 17/02**, G06T 9/00

(86) International application number:
**PCT/US2002/006224**

(87) International publication number:
**WO 2002/078182 (03.10.2002 Gazette 2002/40)**

(54) **TWO-DIMENSIONAL PYRAMID FILTER ARCHITECTURE**

ZWEIDIMENSIONALE PYRAMIDENFILTERARCHITEKTUR

ARCHITECTURE DE FILTRE PYRAMIDAL BIDIMENSIONNELLE

(84) Designated Contracting States:
**AT BE CH CY DE DK ES FI FR GB GR IE IT LI LU MC NL PT SE TR**

(30) Priority: **26.03.2001 US 817711**

(43) Date of publication of application:
**14.01.2004 Bulletin 2004/03**

(73) Proprietor: **INTEL CORPORATION**
**Santa Clara, CA 95052 (US)**

(72) Inventor: **ACHARYA, Tinku**
**Chandler, AZ 85226 (US)**

(74) Representative: **Molyneaux, Martyn William et al**
**Harrison Goddard Foote**
**40-43 Chancery Lane**
**London WC2A 1JA (GB)**

(56) References cited:
**US-A- 4 703 514** **US-A- 5 561 617**

- **CASTLEMAN K R ET AL: "Simplified design of steerable pyramid filters" CIRCUITS AND SYSTEMS, 1998. ISCAS '98. PROCEEDINGS OF THE 1998 IEEE INTERNATIONAL SYMPOSIUM ON MONTEREY, CA, USA 31 MAY-3 JUNE 1998, NEW YORK, NY, USA,IEEE, US, 31 May 1998 (1998-05-31), pages 329-332, XP010289971 ISBN: 0-7803-4455-3**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 380 107 B1

Printed by Jouve, 75001 PARIS (FR)

## Description

### RELATED APPLICATIONS

This patent application is related to EP-A-1396081, titled "Two-dimensional Pyramid Filter Architecture", EP-A-1390914, titled "Two-dimensional Pyramid Filter Architecture", EP-A-1374400, titled "Two-dimensional Pyramid Filter Architecture", and EP-A-1350224, titled "Multiplierless Pyramid Filter" by Tinku Acharya, assigned to the assignee of the present invention.

### BACKGROUND

This disclosure is related to pyramid filters.

In image processing it is often desirable to decompose an image, such as a scanned color image, into two or more separate image representations. For example, a color or grayscale document image can be decomposed into background and foreground images for efficient image processing operations, such as enhancement, compression, etc., as are at times applied in a typical photocopying machine or scanner device. In this context, this operation is often referred to as a descreening operation. This descreening is also sometimes applied to remove halftone patterns that may exist in an original scanned image. For example, hese halftone patterns may cause objectionable artifacts for human eyes if not properly removed. The traditional approach for this decomposition or descreening is to filter the color image in order to blur it. These blurred results are then used to assist in determining how much to blur and sharpen the image in order to produce the decomposition. Typically this blurring can be achieved using a "symmetric pyramid" filter. Symmetric pyramid finite impulse response (FIR) filters are well-known.

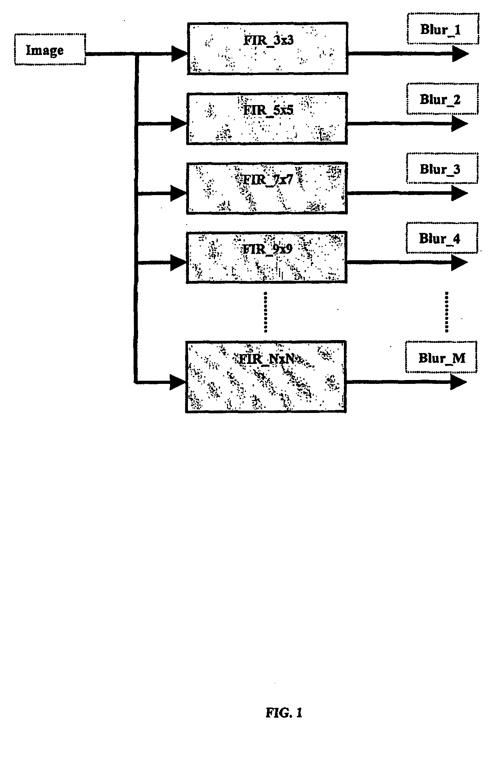

One disadvantage of this image processing technique, however, is that the complexity increases many fold when a number of pyramid filters of different sizes are applied in parallel in order to generate multiple blurred images, to apply the technique as just described. A brute force approach for this multiple pyramid filtering approach is to use multiple FIR filters in parallel, as illustrated in FIG. 1. Such an approach demonstrates that the design and implementation of fast "symmetric pyramid filtering" architectures to generate different blurred images in parallel from a single source image may be desirable.

The numbers provided in parenthesis for each FIR block in FIG. 1 represents the pyramid filter of corresponding length. For example, (1, 2, 1) are the filter coefficients for a symmetric pyramid finite impulse response (FIR) filter of order or length 3. Likewise, (1, 2, 3, 2, 1) are the coefficients for an FIR pyramid filter of order 5, and so forth.

Unfortunately, the approach demonstrated in FIG. 1 has disadvantages. For example, inefficiency may result from redundant computations. Likewise, FIR implementations frequently employ multiplier circuits. While implementations exist to reduce or avoid the use of multipliers, such as with shifting and summing circuitry, that may then result in increased clocking and, hence, may reduce circuit through-put. A need, therefore, exists for improving pyramid filtering implementations or architectures.

### BRIEF DESCRIPTION OF THE DRAWINGS

Subject matter is particularly pointed out and distinctly claimed in the concluding portion of the specification. The claimed subject matter, however, both as to organization and method of operation, together with objects, features, and appendages thereof, may best be understood by reference of the following detailed description when read with the accompanying drawings in which:

FIG. 1 is a block diagram illustrating a brute force approach to implementing a finite impulse response (FIR) multiple pyramid filtering architecture;
FIG. 2 is one embodiment of a one-dimensional multiplierless pyramid filter;
FIG. 3 is one embodiment of a two-dimensional pyramid filter architecture;
FIG. 4 is a table/matrix showing an example of a matrix that may result from implementing a two-dimensional pyramid filter architecture, such as one that may be implemented by the embodiment of FIG. 3;
FIG. 5 is a table/matrix showing an example of a two-dimensional signal that may be operated upon by a two-dimensional pyramid filter architecture;
FIG. 6 is a table/matrix showing an example of applying a one-dimensional pyramid filter kernel both row-wise and column-wise;
FIG. 7 is the table/matrix of FIG. 6 for k=9;
FIG. 8 is a table/matrix showing the result of applying a one-dimensional pyramid filter to the rows of a two-dimensional input signal sample matrix; and
FIG. 9 is a table/matrix showing the result of applying a one-dimensional pyramid filter to the columns of a two-dimensional input signal sample matrix.

## DETAILED DESCRIPTION

In the following detailed description, numerous specific details are set forth in order to provide a thorough understanding of the claimed subject matter. However, it will be understood by those skilled in the art that the claimed subject matter may be practiced without these specific details. In other instances, well-known methods, procedures, . components and circuits have not been described in detail in order so as not to obscure the claimed subject matter.

As previously described, pyramid filtering, in particular, symmetric pyramid filtering, may be employed in connection with color images or color image processing in order to decompose or descreen the image, such as into a background and foreground image, for example. Although the claimed subject matter is not limited in scope in this respect, in such a context, pyramid filtering architectures that reduce computational complexity or processing and/or hardware cost are particularly desirable. Likewise, implementations that are multiplerless, that is do not specifically employ multiplication in the implementation, are also desirable usually because such implementations or embodiments are cheaper to implement than those that employ or include multiplier circuits.

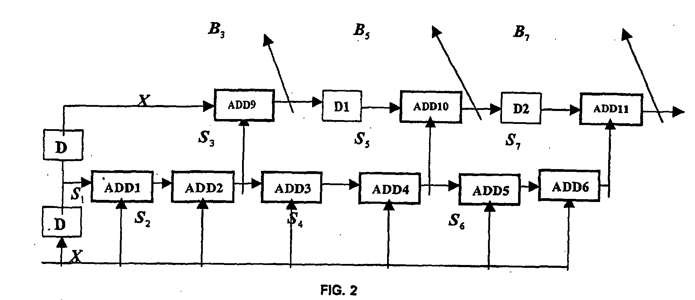

Although the claimed scope is not limited in scope in this respect, FIG. 2 illustrates an embodiment 200 of a one-dimensional pyramid filter, such as described in more detail in aforementioned Patent Application EP-A-1350224, titled "Multiplierless Pyramid Filter," by T. Acharya. Embodiment 200 comprises a unified multiplierless cascaded symmetric pyramid filtering architecture to generate a multiple number of filtered output signal streams for a series or sequence of pyramid filters having different orders, the generation of the output signal streams occurring in parallel. In this particular embodiment, although, again, the claimed subject matter is not limited in scope in this respect, a filtered output signal stream is produced on every clock cycle for each pyramid filter of a different order being implemented. Therefore, in addition to being computationally efficient, this particular embodiment produces good results in terms of throughput. However, as previously indicated, this particular embodiment implements a one-dimensional pyramid filter.

FIG. 2 is understood in the context of specific notation. For example, an input source signal, X, may be designated as follows:

$$X = (x_0, x_1, ..., x_{i-2}, x_{i-1}, x_i, x_{i+1}, x_{i+2}, ....)$$

In digital or discrete signal processing, filtering may be expressed as a convolution, ⊗, of the input signal, X, and a filter, F, in this context a digital filter of finite length, referred to here as a finite impulse response (FIR) filter. Therefore, the filtered output signal stream is indicated as follows:

$$Y=X\otimes F$$

As previously described, the particular embodiment in FIG. 2 employs pyramid filters. These filters are typically implemented using digital filters of lengths or orders that are odd, such as 3, 5, 7, 9, etc. Odd numbers or orders, in this context, may be expressed in the form 2N-1, where N is a positive integer greater than two, for example. Some examples of such digital filters are as follows:

$$F_3=(1,2,1)$$

$$F_5=(1,2,3,2,1)$$

$$F_7=(1,2,3,4,3,2,1)$$

$$F_9 = (1,2,3,4,5,4,3,2,1)$$

...

$$F_M = (1, 2, 3, \dots, N, \dots, 3, 2, 1)$$

(where, in this context, M = 2N-1)

For the foregoing filters, the filtered output signals or output signal streams may be represented as follows:

$$B^3 = X \otimes F_3 = (b_0^3, b_1^3, \dots, b_{i-1}^3, b_i^3, b_{i+1}^3, \dots)$$

result of input signal X filtered by $F_3$

$$B^5 = X \otimes F_5 = (b_0^5, b_1^5, \dots, b_{i-1}^5, b_i^5, b_{i+1}^5, \dots)$$

result of input signal X filtered by $F_5$

$$B^7 = X \otimes F_7 = (b_0^7, b_1^7, \dots, b_{i-1}^7, b_i^7, b_{i+1}^7, \dots)$$

result of input signal X filtered by $F_7$

$$B^9 = X \otimes F_9 = (b_0^9, b_1^9, \dots, b_{i-1}^9, b_i^9, b_{i+1}^9, \dots)$$

result of input signal X filtered by $F_9$

.....

$$B^M = X \otimes F_M = (b_0^M, b_1^M, \dots, b_{i-1}^M, b_i^M, b_{i+1}^M, \dots)$$

result of input signal X filtered by $F_M$

An alternate way to empirically represent these filtered output signal samples is as follows:

$$b_i^3 = x_{i-1} + 2x_i + x_{i+1}$$

$$b_i^5 = x_{i-2} + 2x_{i-1} + 3x_i + 2x_{i+1} + x_{i+2}$$

$$b_i^7 = x_{i-3} + 2x_{i-2} + 3x_{i-1} + 4x_i + 3x_{i+1} + 2x_{i+2} + x_{i+3}$$

$$b_i^9 = x_{i-4} + 2x_{i-3} + 3x_{i-2} + 4x_{i-1} + 5x_i + 4x_{i+1} + 3x_{i+2} + 2x_{i+3} + x_{i+4}$$

Likewise, by introducing what is referred to, in this context, as state variables, the above expressions may be re-expressed as follows:

$$b_i^3 = x_i + s_i^3,$$

where $s_i^3 = x_{i-1} + x_i + x_{i+1}$

$$b_i^5 = b_i^3 + s_i^5,$$

where $s_i^5 = x_{i-2} + x_{i-1} + x_i + x_{i+1} + x_{i+2}$

$$b_i^7 = b_i^5 + s_i^7 ,$$

where $s_i^7 = x_{i-3} + x_{i-2} + x_{i-1} + x_i + x_{i+1} + x_{i+2} + x_{i+3}$

$$b_i^9 = b_i^7 + s_i^9 ,$$

where $s_i^9 = x_{i-4} + x_{i-3} + x_{i-2} + x_{i-1} + x_i + x_{i+1} + x_{i+2} + x_{i+3} + x_{i+4}$
Hence, the desired pyramid filter may be expressed as follows:

$$B^3 = X + S_3,$$

where $S_3 = (s_0^3, s_1^3, s_2^3, ..., s_{i-1}^3, s_i^3, s_{i+1}^3, ...)$

$$B^5 = B^3 + S_5,$$

where $S_3 = (s_0^5, s_1^5, s_2^5, ..., s_{i-1}^5, s_i^5, s_{i+1}^5, ...)$

$$B^7 = B^5 + S_7,$$

where $S_7 = (s_0^7, s_1^7, s_2^7, ..., s_{i-1}^7, S_i^7, S_{i+1}^7, ...)$

$$B^9 = B^7 + S_9 ,$$

where $S_9 = (s_0^9, s_1^9, s_2^9, ..., s_{i-1}^9, s^9, s_{i+1}^9, ...)$

A study of FIG. 2 illustrates that the computed output signal streams, $B_3$, $B_5$, $B_7$, $B_9$, etc. of the pyramid filters shown in FIG. 2 are produced by the embodiment illustrated.

The previous discussion of pyramid filters occurs in the context of one-dimensional filtering; however, due at least in part to the symmetric nature of such filters, it is possible to implement pyramid two-dimensional filtering instead of computing in a row-wise and column-wise one-dimensional fashion that employs extra computational steps. If we represent the one-dimensional ***k***-tap pyramid filter as

$$\boldsymbol{F_k} = \begin{bmatrix} 1 & 2 & 3 & \cdots & \frac{\boldsymbol{k}-1}{2} & \cdots & 3 & 2 & 1 \end{bmatrix},$$

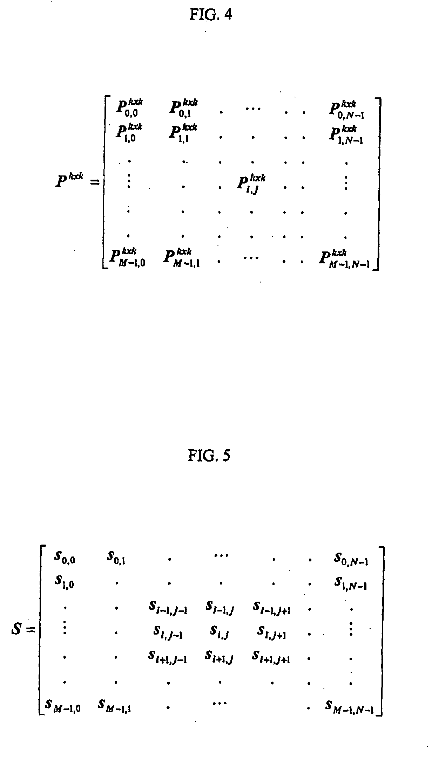

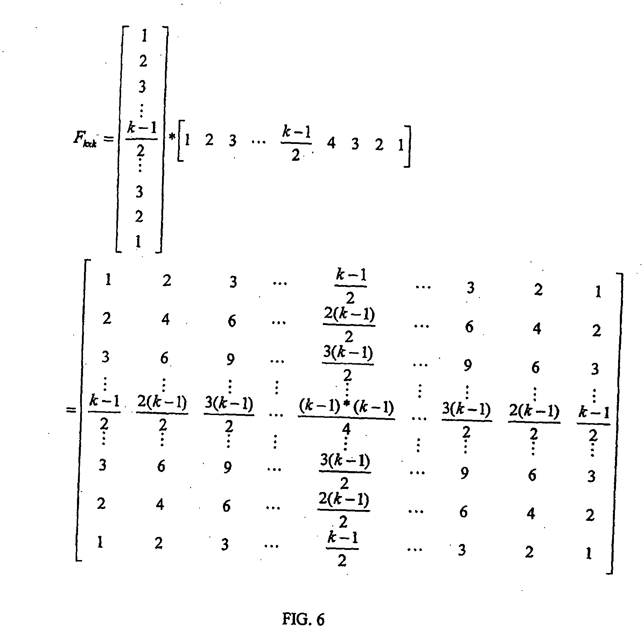

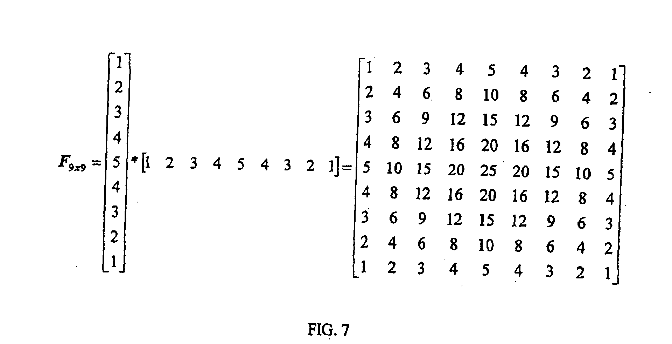

the corresponding two dimensional pyramid filter $F_{kxk}$ may be derived as shown in FIG. 6. In FIG. 7, we have shown the two-dimensional pyramid filter kernel for k=9. Assuming a two-dimensional input signal, e.g, signal samples, having the form shown in FIG. 5, FIG. 4 is a table illustrating a matrix that may result, here a two-dimensional filtered signal sample output matrix, $P^{kxk}$, in which the two dimensional input signal sample matrix is filtered using two-dimensional pyramid filter kernel $F_{kxk}$,.

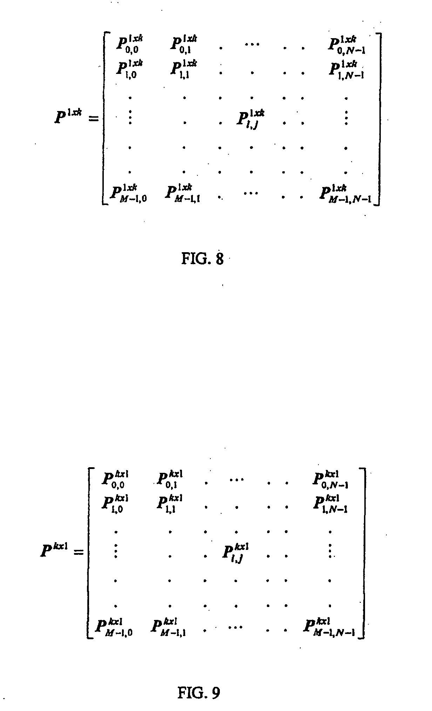

The matrix shown in FIG. 8 may result from applying a one-dimensional k-tap pyramid filter in every row of the two-dimensional input signal sample matrix and the matrix shown in FIG. 9 may result from applying a one-dimensional k-tap pyramid filter in every column of the two-dimensional input signal sample matrix. The matrix in FIG. 4 may result from applying the two-dimensional (k x k) tap filter to the two dimensional input signal sample matrix or, alternatively, it may result from applying the one-dimensional k-tap pyramid filter row-wise and then followed by column-wise. Applying this approach to generate filtered signal samples outputs $P^{1x3}$, $P^{3x1}$, and $P^{3x3}$, produces the following relationships:

$$P_{i,j}^{1x3} = s_{i,j-1} + 2s_{i,j} + s_{i,j+1}$$

$$P_{i,j}^{3x1} = s_{i-1,j} + 2s_{i,j} + s_{i+1,j}$$

$$P_{i,j}^{3x3} = s_{i-1,j-1} + 2s_{i-1,j} + s_{i-1,j+1} + 2s_{i,j-1} + 4s_{i,j} + 2s_{i,j+1} + s_{i+1,j-1} + 2s_{i+1,j} + s_{i+1,j+1}$$

Likewise, generating filtered signal samples outputs $P^{1x5}$, $P^{5x1}$, and $P^{5x5}$, produces the following relationships:

$$P_{i,j}^{5x1} = s_{i-2,j} + 2s_{i-1,j} + 3s_{i,j} + 2s_{i+1,j} + s_{i+2,j}$$

$$P_{i,j}^{1x5} = s_{i,j-2} + 2s_{i,j-1} + 3s_{i,j} + 2s_{i,j+1} + s_{i,j+2}$$

$$P_{i,j}^{5x5} = (s_{i-2,j-2} + 2s_{i-2,j-1} + 3s_{i-2,j} + 2s_{i-2,j+1} + s_{i-2,j+2}) + (2s_{i-1,j-2} + 4s_{i-1,j-1} + 6s_{i-1,j} + 4s_{i-1,j+1} + 2s_{j-1,j+2}) + (3s_{i,j-2} + 6s_{i,j-1} + 9s_{i,j} + 6s_{i,j+1} + 3s_{i,j+2}) + (2s_{i+1,j-2} + 4s_{i+1,j-1} + 6s_{i+1,j} + 4s_{i+1,j+1} + 2s_{i+1,j+2}) + (s_{i+2,j-2} + 2s_{i+2,j-1} + 3s_{i+2,j} + 2s_{i+2,j+1} + s_{i+2,j+2})$$

Mathematical manipulation of these equations produces the following result:

$$P_{i,j}^{5x5} = (P_{i,j}^{5x1} + P_{i,j}^{1x5}) + (P_{i-1,j-1}^{3x3} + P_{i-1,j+1}^{3x3} + P_{i+1,j-1}^{3x3} + P_{i+1,j+1}^{3x3}) - s_{i,j} \quad [1]$$

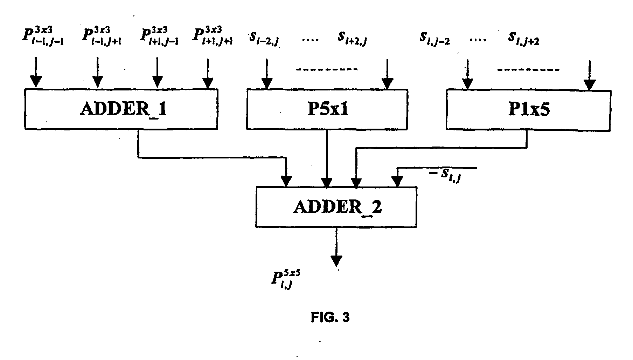

Equation [1] above illustrates that a direct two-dimensional pyramid filter architecture of order 2N-1, in this case where N is three, may potentially be implemented using either four two-dimensional pyramid filters of order [2(N-1)-1] or one two-dimensional pyramid filter of order [2(N-1)-1] using four signal sample matrices $P_{i-1,j-1}^{3x3}$, $P_{i-1,j+1}^{3x3}$, $P_{i+1,j-1}^{3x3}$, $P_{i+1,j+1}^{3x3}$ and two one-dimensional pyramid filters of order 2N-1, here row-wise and column-wise, in this example. FIG. 3 is a schematic diagram illustrating such an embodiment, although, of course, the claimed subject matter is not limited in scope to this particular implementation or embodiment. For example, the output signal samples corresponding to those produced by four two-dimensional pyramid filters of order 2(N-1)-1, here order three where N is three, may not necessarily be produced by two-dimensional pyramid filters. As just one example, these output signals may be produced using one-dimensional pyramid filters. One such filter is shown in FIG. 2, although, again, additional approaches to producing the output signals for the architecture shown in FIG. 3 may also be employed.

FIG. 3 illustrates an integrated circuit (IC), 300, although, of course, alternative embodiments may not necessarily be implemented on a single integrated circuit chip. IC 300 includes a two-dimensional pyramid filter architecture of an order 2N-1, where N is a positive integer greater than two, here three. This two-dimensional pyramid filter architecture of order 2N-1, or order five here, in operation, is capable of producing, on respective clock cycles, at least the following. Pyramid filtered output signals are produced corresponding to output signals produced by two one-dimensional pyramid filters of order 2N-1, again, five in this example where N is three, 330 and 340 in FIG. 3. Pyramid filtered output signals are also produced corresponding to output signals produced either by four two-dimensional pyramid filters or one two-dimensional pyramid of order [2(N-1)-1] or three here, where N is three, using signal sample matrices $P_{i-1,j-1}^{3x3}$, $P_{i-1,j+1}^{3x3}$, $P_{i+1,j-1}^{3x3}$, $P_{i+1,j+1}^{3x3}$. These output signals are summed by adder 310 in FIG. 3. Likewise, the respective output signals in this two dimensional pyramid filter architecture implementation, in the implementation in FIG. 3, for example, the output signals of 310, 330 and 340, are summed on respective clock cycles of the two dimensional pyramid filter architecture, by adder 320 in FIG. 3. Of course, FIG. 3 is just one possible example of an implementation and the claimed subject matter is not limited in scope to this or to another particular implementation.

For example, N is not limited to three. Likewise, the pyramid filtered output signals that correspond to output signals produced by a two-dimensional pyramid filter are not limited to being implemented by one-dimensional pyramid filters or to two-dimensional pyramid filters. Likewise, as previously indicated, if one-dimensional filters are employed, then the filters are not limited to the implementation approach described in aforementioned Patent Application EP-A-1350224, titled "Multiplierless Pyramid Filter," by Tinku Acharya. For example, one-dimensional pyramid filters other than multiplierless pyramid filters may be employed. Likewise, depending on the implementation, different numbers of such pyramid filters and different orders of such pyramid filters may be employed. For example, the output signals may be combined or processed in a way to produce pyramid filtered output signals corresponding to pyramid filters of a different number, dimension, or order.

It will, of course, be understood that, although particular embodiments have just been described, the invention is not limited in scope to a particular embodiment or implementation. For example, one embodiment may be in hardware, whereas another embodiment may be in software. Likewise, an embodiment may be in firmware, or any combination of hardware, software, or firmware, for example. Likewise, although the invention is not limited in scope in this respect, one embodiment may comprise an article, such as a storage medium. Such a storage medium, such as, for example, a CD-ROM, or a disk, may have stored thereon instructions, which when executed by a system, such as a computer system or platform, or an imaging system, for example, may result in an embodiment of a method in accordance with the present invention being executed, such as an embodiment of a method of filtering or processing an image or video, for example, as previously described. For example, an image processing platform or an imaging processing system may include an image processing unit, a video or image input/output device and/or memory.

While certain features of the invention have been illustrated and described herein, many modifications, substitutions, changes and equivalents will now occur to those skilled in the art. It is, therefore, to be understood that the appended claims are intended to cover all such modifications and changes.

## Claims

1. An integrated circuit comprising:

   a two-dimensional pyramid filter architecture of an order 2N-1, where N is a positive integer greater than two; said two dimensional pyramid filter architecture of order 2N-1, in operation, capable of producing, on respective clock cycles, at least the following:

   pyramid filtered output signals corresponding to output signals produced by two one-dimensional pyramid filters of order 2N-1; and
   pyramid filtered output signals corresponding to output signals produced either by four two-dimensional pyramid filters or one two-dimensional pyramid filter of order [2(N-1) - 1] using signal sample matrices of order [2(N-1)-1];

   wherein the respective output signals in said two dimensional pyramid filter architecture are summed on respective clock cycles of said two dimensional pyramid filter architecture.

2. The integrated circuit of claim 1, wherein N is three; and
   wherein said two dimensional pyramid filter architecture of order five, in operation, capable of producing, on respective clock cycles, the pyramid filtered output signals corresponding to output signals produced either by four two-dimensional pyramid filter or one two-dimensional pyramid of order three using four signal sample matrices $P^{3x3}_{i-1,j-1}$, $P^{3x3}_{i-1,j+1}$, $P^{3x3}_{i+1,j-1}$, $P^{3x3}_{i+1,j+1}$, the pyramid filtered output signals being produced by a plurality of one-dimensional pyramid filters.

3. The integrated circuit of claim 2, wherein said one-dimensional pyramid filters comprise a sequence of scalable cascaded multiplerless operational units, each of said operational units capable of producing a different order pyramid filtered output signal sample stream.

4. The integrated circuit of claim 2, wherein said one-dimensional pyramid filters comprise other than one-dimensional multiplierless pyramid filters.

5. The integrated circuit of claim 2, wherein said two dimensional pyramid filter architecture of order five, in operation, capable of producing, on respective clock cycles, the pyramid filtered output signals corresponding to output signals produced either by four two-dimensional pyramid filters or one two-dimensional pyramid of order three using four signal sample matrices $P^{3x3}_{i-1,j-1}$, $P^{3x3}_{i-1,j+1}$, $P^{3x3}_{i+1,j-1}$, $P^{3x3}_{i+1,j+1}$, the pyramid filtered output signals produced by a plurality of one-dimensional pyramid filters being produced by eight one-dimensional pyramid filters of order three.

6. The integrated circuit of claim 5, wherein, of the eight one-dimensional pyramid filters of order three, four are applied row-wise and four are applied column-wise.

7. The integrated circuit of claim 5, wherein said two dimensional pyramid filter architecture of order five, in operation, capable of producing, on respective clock cycles, the pyramid filtered output signals corresponding to output signals produced by four two-dimensional pyramid filters of order three, the pyramid filtered output signals produced by a plurality of one-dimensional pyramid filters being produced by eight one-dimensional multiplierless pyramid filters of order three.

**8.** The integrated circuit of claim 7, wherein, of the eight one-dimensional pyramid filters of order three, four are applied row-wise and four are applied column-wise.

**9.** The integrated circuit of claim 2, wherein said two dimensional pyramid filter architecture of order five, in operation, capable of producing, on respective clock cycles, the pyramid filtered output signals corresponding to output signals produced by four two-dimensional pyramid filters of order three, the pyramid filtered output signals produced by a plurality of one-dimensional pyramid filters being produced by other than one-dimensional multiplierless pyramid filters.

**10.** The integrated circuit of claim 1, wherein N is three;
said two dimensional pyramid filter architecture of order five, in operation, being capable of producing, on respective clock cycles, at least the following:

output signals produced by four two-dimensional pyramid filters of order three.

**11.** The integrated circuit of claim 1, wherein said two dimensional pyramid filter architecture of order five, in operation, capable of producing, on respective clock cycles, the pyramid filtered output signals corresponding to output signals produced by four two-dimensional pyramid filters of order three, the pyramid filtered output signals being produced by two-dimensional pyramid filters other than four two-dimensional pyramid filters.

**12.** A method of filtering an image using a two-dimensional pyramid filter architecture of order 2N-1, where N is a positive integer greater than two, said method comprising:

summing, on respective clock cycles of said two dimensional pyramid filter architecture, the following:

pyramid filtered output signals corresponding to output signals produced by two one-dimensional pyramid filters of order 2N-1; and
pyramid filtered output signals corresponding to output signals produced either by four two-dimensional pyramid filters or one two-dimensional pyramid filter of order [2(N-1)-1] using signal sample matrices of order [2(N-1)-1].

**13.** The method of claim 12, wherein N is three;
pyramid filtered output signals corresponding to output signals produced either by four two-dimensional pyramid filters or one two-dimensional pyramid filter of order [2(N-1) - 1] using signal sample matrices of order [2(N-1)-1] comprising output signals produced by four two-dimensional pyramid filters of order three.

**14.** The method of claim 12, wherein N is three; and
wherein the pyramid filtered output signals corresponding to output signals produced either by four two-dimensional pyramid filters or one two-dimensional pyramid of order three using four signal sample matrices $P^{3x3}_{i-1,j-1}$, $P^{3x3}_{i-1,j+1}$, $P^{3x3}_{i+1,j-1}$, $P^{3x3}_{i+1,j+1}$, comprise pyramid filtered output signals produced by a plurality of one-dimensional pyramid filters.

**15.** A storage medium having stored thereon instructions, that, when executed result in filtering an image using a two-dimensional pyramid filter architecture of order 2N-1, where N is a positive integer greater than two, by:

summing, on respective clock cycles of said two dimensional pyramid filter architecture, the following:

pyramid filtered output signals corresponding to output signals produced by two one-dimensional pyramid fibers of order 2N-1; and
pyramid filtered output signals corresponding to output signals produced either by four two-dimensional pyramid filters or one two-dimensional pyramid filter of order [2(N-1)-1] using signal sample matrices of order [2(N-1)-1].

**16.** The storage medium of claim 15, wherein N is three; and
wherein the pyramid filtered output signals corresponding to output signals produced either by four two-dimensional pyramid filters or one two-dimensional pyramid of order three using four signal sample matrices $P^{3x3}_{i-1,j-1}$, $P^{3x3}_{i-1,j+1}$, $P^{3x3}_{i+1,j-1}$, $P^{3x3}_{i+1,j+1}$, comprise pyramid filtered output signals produced by a plurality of one-dimensional pyramid filters.

**17.** The storage medium of claim 16 ,wherein said one-dimensional pyramid filters comprise a sequence of scalable cascaded multiplerless operational units, each of said operational units capable of producing a different order pyramid filtered output signal sample stream.

**18.** An image processing system comprising:

an image processing unit to filter scanned color images;
said image processing unit including at least one two-dimensional pyramid filter architecture;
said at least one two-dimensional pyramid filter architecture comprising:

a two-dimensional pyramid filter architecture of an order 2N-1, where N is a positive integer greater than two;
said two dimensional pyramid filter architecture of order 2N-1, in operation, capable of producing, on respective clock cycles, at least the following:

pyramid filtered output signals corresponding to output signals produced by two one-dimensional pyramid filters of order 2N-1; and
pyramid filtered output signals corresponding to output signals produced either by four two-dimensional pyramid filters or one two-dimensional pyramid fitter of order [2(N-1) -1] using signal sample matrices of order [2(N-1)-1];

wherein the respective output signals in said two dimensional pyramid filter architecture are summed on respective clock cycles of said two dimensional pyramid filter architecture.

**19.** The system of claim 18 ,wherein N is three;
pyramid filtered output signals corresponding to output signals produced either by four two-dimensional pyramid filters or one two-dimensional pyramid filter of order [2(N-1) - 1] using signal sample matrices of order [2(N-1)-1] comprising output signals produced by four two-dimensional pyramid filters of order three.

**20.** The system of claim 18, wherein N is three; and
wherein the pyramid filtered output signals corresponding to output signals produced either by four two-dimensional pyramid filters or one two-dimensional pyramid of order three using four signal sample matrices $P^{3x3}_{i-1,j-1}$, $P^{3x3}_{i-1,j+1}$, $P^{3x3}_{i+1,j-1}$, $P^{3x3}_{i+1,j+1}$, comprise pyramid filtered output signals produced by a plurality of one-dimensional pyramid filters.

**21.** The system of claim 20 ,wherein said one-dimensional pyramid filters comprise a sequence of scalable cascaded multiplerless operational units, each of said operational units capable of producing a different order pyramid filtered output signal sample stream.

## Patentansprüche

**1.** Integrierte Schaltung, die folgendes umfasst:

eine zweidimensionale Pyramidenfilterarchitektur einer Ordnung 2N-1, wobei N eine positive ganze Zahl darstellt, die größer ist als zwei;

wobei die genannte zweidimensionale Pyramidenfilterarchitektur einer Ordnung 2N-1 im Betrieb in der Lage ist, bei entsprechenden Taktzyklen zumindest folgendes zu erzeugen:

pyramidengefilterte Ausgangssignale, die Ausgangssignalen entsprechen, die durch zwei eindimensionale Pyramidenfilter einer Ordnung 2N-1 erzeugt werden; und
pyramidengefilterte Ausgangssignale, die Ausgangssignalen entsprechen, die entweder von vier zweidimensionalen Pyramidenfiltern oder einem zweidimensionalen Pyramidenfilter der Ordnungen [2(N-1)-1] unter Verwendung von Signalabtastmatrizen der Ordnung [2(N-1)-1] erzeugt werden;

wobei die entsprechenden Ausgangssignale in der genannten zweidimensionalen Pyramidenfilterarchitektur an entsprechenden Taktzyklen der genannten zweidimensionalen Pyramidenfilterarchitektur summiert werden.

**2.** Integrierte Schaltung nach Anspruch 1, wobei N gleich drei ist; und

wobei die genannte zweidimensionale Pyramidenfilterarchitektur der fünften Ordnung im Betrieb an entsprechenden Taktzyklen die pyramidengefilterten Ausgangssignale erzeugen kann, die Ausgangssignalen entsprechen, die entweder durch vier zweidimensionale Pyramidenfilter oder eine zweidimensionale Pyramide der dritten Ordnung unter Verwendung von vier Signalabtastmatrizen $P^{3x3}_{i-1,j-1}$, $P^{3x3}_{i-1,j+1}$, $P^{3x3}_{i+1,j-1}$, $P^{3x3}_{i+1,j+1}$ erzeugt werden, wobei die pyramidengefilterten Ausgangssignale durch eine Mehrzahl eindimensionaler Pyramidenfilter erzeugt werden.

**3.** Integrierte Schaltung nach Anspruch 2, wobei die genannten eindimensionalen Pyramidenfilter eine Sequenz skalierbarer, kaskadierter, multipliziererfreier Operationseinheiten umfassen, wobei jede der genannten Operationseinheiten in der Lage ist, einen pyramidengefilterten Ausgangssignalabtaststrom einer anderen Ordnung zu erzeugen.

**4.** Integrierte Schaltung nach Anspruch 2, wobei die genannten eindimensionalen Pyramidenfilter andere als eindimensionale multipliziererfreie Pyramidenfilter umfassen.

**5.** Integrierte Schaltung nach Anspruch 2, wobei die genannte zweidimensionale Pyramidenfilterarchitektur der fünften Ordnung im Betrieb an entsprechenden Taktzyklen die pyramidengefilterten Ausgangssignale erzeugen kann, die Ausgangssignalen entsprechen, die entweder durch vier zweidimensionale Pyramidenfilter oder eine zweidimensionale Pyramide der dritten Ordnung unter Verwendung von vier Signalabtastmatrizen $P^{3x3}_{i-1,j-1}$, $P^{3x3}_{i-1,j+1}$, $P^{3x3}_{i+1,j-1}$, $P^{3x3}_{i+1,j+1}$ erzeugt werden, wobei die pyramidengefilterten Ausgangssignale durch eine Mehrzahl eindimensionaler Pyramidenfilter erzeugt werden, die durch acht eindimensionale Pyramidenfilter der dritten Ordnung erzeugt werden.

**6.** Integrierte Schaltung nach Anspruch 5, wobei von den acht eindimensionalen Pyramidenfilter der dritten Ordnung vier zeilenweise und vier spaltenweise eingesetzt werden.

**7.** Integrierte Schaltung nach Anspruch 5, wobei die genannte zweidimensionale Pyramidenfilterarchitektur der fünften Ordnung im Betrieb an entsprechenden Taktzyklen die pyramidengefilterten Ausgangssignale erzeugen kann, die Ausgangssignalen entsprechen, die durch vier zweidimensionale Pyramidenfilter der dritten Ordnung erzeugt werden, wobei die pyramidengefilterten Ausgangssignale durch eine Mehrzahl eindimensionaler Pyramidenfilter erzeugt werden, die durch acht eindimensionale, multipliziererfreie Pyramidenfilter der dritten Ordnung erzeugt werden.

**8.** Integrierte Schaltung nach Anspruch 7, wobei von den acht eindimensionalen Pyramidenfilter der dritten Ordnung vier zeilenweise und vier spaltenweise eingesetzt werden.

**9.** Integrierte Schaltung nach Anspruch 2, wobei die genannte zweidimensionale Pyramidenfilterarchitektur der fünften Ordnung im Betrieb an entsprechenden Taktzyklen die pyramidengefilterten Ausgangssignale erzeugen kann, die Ausgangssignalen entsprechen, die durch vier zweidimensionale Pyramidenfilter der dritten Ordnung erzeugt werden, wobei die pyramidengefilterten Ausgangssignale durch eine Mehrzahl eindimensionaler Pyramidenfilter erzeugt werden, die durch andere als eindimensionale, multipliziererfreie Pyramidenfilter erzeugt werden.

**10.** Integrierte Schaltung nach Anspruch 1, wobei N gleich drei ist;

wobei die genannte zweidimensionale Pyramidenfilterarchitektur der fünften Ordnung im Betrieb in der Lage ist, an entsprechenden Taktzyklen mindestens folgendes zu erzeugen:

Ausgangssignale, die durch vier zweidimensionale Pyramidenfilter der dritten Ordnung erzeugt werden.

**11.** Integrierte Schaltung nach Anspruch 1, wobei die genannte zweidimensionale Pyramidenfilterarchitektur der fünften Ordnung im Betrieb an entsprechenden Taktzyklen die pyramidengefilterten Ausgangssignale erzeugen kann, die Ausgangssignalen entsprechen, die durch vier zweidimensionale Pyramidenfilter der dritten Ordnung erzeugt werden, wobei die pyramidengefilterten Ausgangssignale durch andere zweidimensionale Pyramidenfilter als vier zweidimensionale Pyramidenfilter erzeugt werden.

**12.** Verfahren zum Filtern eines Bildes unter Verwendung einer zweidimensionalen Pyramidenfilterarchitektur der Ordnung 2N-1, wobei N eine positive ganze Zahl darstellt, die größer ist als zwei, wobei das genannte Verfahren folgendes umfasst:

Summieren des Folgenden an entsprechenden Taktzyklen der genannten zweidimensionalen Pyramidenfilterarchitektur:

pyramidengefilterte Ausgangssignale, die Ausgangssignalen entsprechen, die durch zwei eindimensionale Pyramidenfilter einer Ordnung 2N-1 erzeugt werden; und
pyramidengefilterte Ausgangssignale, die Ausgangssignalen entsprechen, die entweder von vier zweidimensionalen Pyramidenfiltern oder einem zweidimensionalen Pyramidenfilter der Ordnungen [2(N-1)-1] unter Verwendung von Signalabtastmatrizen der Ordnung [2(N-1)-1] erzeugt werden.

**13.** Verfahren nach Anspruch 12, wobei N gleich drei ist:
wobei pyramidengefilterte Ausgangssignale, die Ausgangssignalen entsprechen, die entweder von vier zweidimensionalen Pyramidenfiltern oder einem zweidimensionalen Pyramidenfilter der Ordnungen [2(N-1)-1] unter Verwendung von Signalabtastmatrizen der Ordnung [2(N-1)-1] erzeugt werden, Ausgangssignale umfassen, die durch vier zweidimensionale Pyramidenfilter der dritten Ordnung erzeugt werden.

**14.** Verfahren nach Anspruch 12, wobei N gleich drei ist; und
wobei die pyramidengefilterten Ausgangssignale, die Ausgangssignalen entsprechen, die entweder durch vier zweidimensionale Pyramidenfilter oder eine zweidimensionale Pyramide der dritten Ordnung unter Verwendung von vier Signalabtastmatrizen $P^{3x3}_{i-1,j-1}, P^{3x3}_{i-1,j+1}, P^{3x3}_{i+1,j-1}, P^{3x3}_{i+1,j+1}$ erzeugt werden, pyramidengefilterte Ausgangssignale umfassen, die durch eine Mehrzahl eindimensionaler Pyramidenfilter erzeugt werden.

**15.** Speichermedium mit darauf gespeicherten Anweisungen, die, wenn sie ausgeführt werden, zum Filtern eines Bilds unter Verwendung einer zweidimensionalen Pyramidenfilterarchitektur der Ordnung 2N-1 führen, wobei N eine positive ganze Zahl darstellt, die größer ist als zwei, **gekennzeichnet durch**:

Summieren des Folgenden an entsprechenden Taktzyklen der genannten zweidimensionalen Pyramidenfilterarchitektur:

pyramidengefilterte Ausgangssignale, die Ausgangssignalen entsprechen, die **durch** zwei eindimensionale Pyramidenfilter einer Ordnung 2N-1 erzeugt werden; und
pyramidengefilterte Ausgangssignale, die Ausgangssignalen entsprechen, die entweder von vier zweidimensionalen Pyramidenfiltern oder einem zweidimensionalen Pyramidenfilter der Ordnungen [2(N-1)-1] unter Verwendung von Signalabtastmatrizen der Ordnung [2(N-1)-1] erzeugt werden.

**16.** Speichermedium nach Anspruch 15, wobei N gleich drei ist; und
wobei die pyramidengefilterten Ausgangssignale, die Ausgangssignalen entsprechen, die entweder durch vier zweidimensionale Pyramidenfilter oder eine zweidimensionale Pyramide der dritten Ordnung unter Verwendung von vier Signalabtastmatrizen $P^{3x3}_{i-1,j-1}, P^{3x3}_{i-1,j+1}, P^{3x3}_{i+1,j-1}, P^{3x3}_{i+1,j+1}$ erzeugt werden, pyramidengefilterte Ausgangssignale umfassen, die durch eine Mehrzahl eindimensionaler Pyramidenfilter erzeugt werden.

**17.** Speichermedium nach Anspruch 16, wobei die genannten eindimensionalen Pyramidenfilter eine Sequenz skalierbarer, kaskadierter, multipliziererfreier Operationseinheiten umfassen, wobei jede der genannten Operationseinheiten in der Lage ist, einen pyramidengefilterten Ausgangssignalabtaststrom einer anderen Ordnung zu erzeugen.

**18.** Bildverarbeitungssystem, das folgendes umfasst:

eine Bildverarbeitungseinheit zum Filtern gescannter Farbbilder;

wobei die genannte Bildverarbeitungseinheit mindestens eine zweidimensionale Pyramidenfilterarchitektur aufweist;
wobei die genannte mindestens eine zweidimensionale Pyramidenfilterarchitektur folgendes umfasst:

eine zweidimensionale Pyramidenfilterarchitektur einer Ordnung 2N-1, wobei N eine positive ganze Zahl darstellt, die größer ist als zwei;

wobei die genannte zweidimensionale Pyramidenfilterarchitektur einer Ordnung 2N-1 im Betrieb in der Lage ist, bei entsprechenden Taktzyklen zumindest folgendes zu erzeugen:

pyramidengefilterte Ausgangssignale, die Ausgangssignalen entsprechen, die durch zwei eindimensionale Pyramidenfilter einer Ordnung 2N-1 erzeugt werden; und
pyramidengefilterte Ausgangssignale, die Ausgangssignalen entsprechen, die entweder von vier zweidimensionalen Pyramidenfiltern oder einem zweidimensionalen Pyramidenfilter der Ordnungen [2(N-1)-1] unter Verwendung von Signalabtastmatrizen der Ordnung [2(N-1)-1] erzeugt werden;

wobei die entsprechenden Ausgangssignale in der genannten zweidimensionalen Pyramidenfilterarchitektur an entsprechenden Taktzyklen der genannten zweidimensionalen Pyramidenfilterarchitektur summiert werden.

**19.** System nach Anspruch 18, wobei N gleich drei ist:
wobei pyramidengefilterte Ausgangssignale, die Ausgangssignalen entsprechen, die entweder von vier zweidimensionalen Pyramidenfiltern oder einem zweidimensionalen Pyramidenfilter der Ordnungen [2(N-1)-1] unter Verwendung von Signalabtastmatrizen der Ordnung [2(N-1)-1] erzeugt werden, Ausgangssignale umfassen, die durch vier zweidimensionale Pyramidenfilter der dritten Ordnung erzeugt werden.

**20.** System nach Anspruch 18, wobei N gleich drei ist; und
wobei die pyramidengefilterten Ausgangssignale, die Ausgangssignalen entsprechen, die entweder durch vier zweidimensionale Pyramidenfilter oder eine zweidimensionale Pyramide der dritten Ordnung unter Verwendung von vier Signalabtastmatrizen $P^{3x3}_{i-1,j-1}, P^{3x3}_{i-1,j+1}, P^{3x3}_{i+1,j-1}, P^{3x3}_{i+1,j+1}$ erzeugt werden, pyramidengefilterte Ausgangssignale umfassen, die durch eine Mehrzahl eindimensionaler Pyramidenfilter erzeugt werden.

**21.** System nach Anspruch 20, wobei die genannten eindimensionalen Pyramidenfilter eine Sequenz skalierbarer, kaskadierter, multipliziererfreier Operationseinheiten umfassen, wobei jede der genannten Operationseinheiten in der Lage ist, einen pyramidengefilterten Ausgangssignalabtaststrom einer anderen Ordnung zu erzeugen.

## Revendications

**1.** Circuit intégré comprenant :

une architecture de filtre pyramidal bidimensionnelle d'un ordre 2N-1, dans laquelle N est un entier positif supérieur à deux ;
ladite architecture de filtre pyramidal bidimensionnelle d'ordre 2N-1, en fonctionnement, pouvant produire, sur des cycles d'horloge respectifs, au moins ce qui suit :

des signaux de sortie soumis à filtre pyramidal correspondant aux signaux de sortie produits par deux filtres pyramidaux unidimensionnels d'ordre 2N-1 ; et
des signaux de sortie soumis à filtre pyramidal correspondant aux signaux de sortie produits soit par quatre filtres pyramidaux bidimensionnels soit par un filtre pyramidal bidimensionnel d'ordre [2(N-1)-1] en utilisant des matrices d'échantillons de signal d'ordre [2(N-1)-1] ;

dans lequel les signaux de sortie respectifs dans ladite architecture de filtre pyramidal bidimensionnelle sont additionnés sur des cycles d'horloge respectifs de ladite architecture de filtre pyramidal bidimensionnelle.

**2.** Circuit intégré selon la revendication 1, dans lequel N est trois ; et
dans lequel ladite architecture de filtre pyramidal bidimensionnelle d'ordre cinq, en fonctionnement, peut produire, sur des cycles d'horloge respectifs, les signaux de sortie soumis à filtre pyramidal correspondant aux signaux de sortie produits soit par quatre filtres pyramidaux bidimensionnels soit par un filtre pyramidal bidimensionnel d'ordre trois en utilisant quatre matrices d'échantillons de signal $P^{3x3}_{i-1,j-1}, P^{3x3}_{i-1,j+1}, P^{3x3}_{i+1,j-1}, P^{3x3}_{i+1,j+1}$, les signaux de sortie soumis à filtre pyramidal étant produits par une pluralité de filtres pyramidaux unidimensionnels.

**3.** Circuit intégré selon la revendication 2, dans lequel lesdits filtres pyramidaux unidimensionnels comprennent une séquence d'unités opérationnelles sans multiplicateur en cascade évolutives, chacune desdites unités opérationnelles pouvant produire un flux d'échantillons de signal de sortie soumis à filtre pyramidal de différent ordre.

**4.** Circuit intégré selon la revendication 2, dans lequel lesdits filtres pyramidaux unidimensionnels comprennent d'autres éléments que des filtres pyramidaux unidimensionnels sans multiplicateur.

**5.** Circuit intégré selon la revendication 2, dans lequel ladite architecture de filtre pyramidal bidimensionnelle d'ordre cinq, en fonctionnement, peut produire, sur des cycles d'horloge respectifs, les signaux de sortie soumis à filtre pyramidal correspondant aux signaux de sortie produits soit par quatre filtres pyramidaux bidimensionnels soit par un filtre pyramidal bidimensionnel d'ordre trois en utilisant quatre matrices d'échantillons de signal $P^{3x3}_{\overline{i-1,j-1}}$, $P^{3x3}_{\overline{i-1,j+1}}$, $P^{3x3}_{\overline{i+1,j-1}}$, $P^{3x3}_{\overline{i+1,j+1}}$, les signaux de sortie soumis à filtre pyramidal produits par une pluralité de filtres pyramidaux unidimensionnels étant produits par huit filtres pyramidaux unidimensionnels d'ordre trois.

**6.** Circuit intégré selon la revendication 5, dans lequel, sur les huit filtres pyramidaux unidimensionnels d'ordre trois, quatre sont appliqués en tenant compte des rangées et quatre sont appliqués en tenant compte des colonnes.

**7.** Circuit intégré selon la revendication 5, dans lequel ladite architecture de filtre pyramidal bidimensionnelle d'ordre cinq, en fonctionnement, peut produire, sur des cycles d'horloge respectifs, les signaux de sortie soumis à filtre pyramidal correspondant aux signaux de sortie produits par quatre filtres pyramidaux bidimensionnels d'ordre trois, les signaux de sortie soumis à filtre pyramidal produits par une pluralité de filtres pyramidaux unidimensionnels étant produits par huit filtres pyramidaux sans multiplicateur unidimensionnels d'ordre trois.

**8.** Circuit intégré selon la revendication 7, dans lequel, sur les huit filtres pyramidaux unidimensionnels d'ordre trois, quatre sont appliqués en tenant compte des rangées et quatre sont appliqués en tenant compte des colonnes.

**9.** Circuit intégré selon la revendication 2, dans lequel ladite architecture de filtre pyramidal bidimensionnelle d'ordre cinq, en fonctionnement, peut produire, sur des cycles d'horloge respectifs, les signaux de sortie soumis à filtre pyramidal correspondant aux signaux de sortie produits par quatre filtres pyramidaux bidimensionnels d'ordre trois, les signaux de sortie soumis à filtre pyramidal produits par une pluralité de filtres pyramidaux unidimensionnels étant produits autrement que par des filtres pyramidaux sans multiplicateur unidimensionnels.

**10.** Circuit intégré selon la revendication 1, dans lequel N est trois ;
ladite architecture de filtre pyramidal bidimensionnelle d'ordre cinq, en fonctionnement, pouvant produire, sur des cycles d'horloge respectifs, au moins ce qui suit :

des signaux de sortie produits par quatre filtres pyramidaux bidimensionnels d'ordre trois.

**11.** Circuit intégré selon la revendication 1, dans lequel ladite architecture de filtre pyramidal bidimensionnelle d'ordre cinq, en fonctionnement, peut produire, sur des cycles d'horloge respectifs, les signaux de sortie soumis à filtre pyramidal correspondant aux signaux de sortie produits par quatre filtres pyramidaux bidimensionnels d'ordre trois, les signaux de sortie soumis à filtre pyramidal étant produits par des filtres pyramidaux bidimensionnels autres que quatre filtres pyramidaux bidimensionnels.

**12.** Procédé de filtrage d'une image utilisant une architecture de filtre pyramidal bidimensionnelle d'ordre 2N-1, dans laquelle N est un entier positif supérieur à deux, ledit procédé comprenant :

l'addition, sur des cycles d'horloge respectifs de ladite architecture de filtre pyramidal bidimensionnelle, de ce qui suit :

des signaux de sortie soumis à filtre pyramidal correspondant aux signaux de sortie produits par deux filtres pyramidaux unidimensionnels d'ordre 2N-1 ; et
des signaux de sortie soumis à filtre pyramidal correspondant aux signaux de sortie produits soit par quatre filtres pyramidaux bidimensionnels soit par un filtre pyramidal bidimensionnel d'ordre [2(N-1)-1] en utilisant des matrices d'échantillons de signal d'ordre [2(N-1)-1].

**13.** Procédé selon la revendication 12, dans lequel N est trois ;
des signaux de sortie soumis à filtre pyramidal correspondent aux signaux de sortie produits soit par quatre filtres pyramidaux bidimensionnels soit par un filtre pyramidal bidimensionnel d'ordre [2(N-1)-1] en utilisant des matrices d'échantillons de signal d'ordre [2(N-1)-1] comprenant des signaux de sortie produits par quatre filtres pyramidaux bidimensionnels d'ordre trois.

**14.** Procédé selon la revendication 12, dans lequel N est trois ; et
dans lequel les signaux de sortie soumis à filtre pyramidal correspondant aux signaux de sortie produits soit par four filtres pyramidaux bidimensionnels soit par un filtre pyramidal bidimensionnel d'ordre trois en utilisant quatre matrices d'échantillons de signal $P^{3x3}_{j-1,j-1}$, $P^{3x3}_{i-1,j+1}$, $P^{3x3}_{i+1,j-1}$, $P^{3x3}_{i+1,j+1}$, comprennent des signaux de sortie soumis à filtre pyramidal produits par une pluralité de filtres pyramidaux unidimensionnels.

**15.** Support de stockage ayant stocké dessus des instructions, qui, lorsqu'elles sont exécutées entraînent le filtrage d'une image en utilisant une architecture de filtre pyramidal bidimensionnelle d'ordre 2N-1, dans laquelle N est un entier positif supérieur à deux, en :

ajoutant, sur des cycles d'horloge respectifs de ladite architecture de filtre pyramidal bidimensionnelle, ce qui suit :

des signaux de sortie soumis à filtre pyramidal correspondant aux signaux de sortie produits par deux filtres pyramidaux unidimensionnels d'ordre 2N-1 ; et
des signaux de sortie soumis à filtre pyramidal correspondant aux signaux de sortie produits soit par quatre filtres pyramidaux bidimensionnels soit par un filtre pyramidal bidimensionnel d'ordre [2(N-1)-1] en utilisant des matrices d'échantillons de signal d'ordre [2(N-1)-1].

**16.** Support de stockage selon la revendication 15, dans lequel N est trois ; et
dans lequel les signaux de sortie soumis à filtre pyramidal correspondant aux signaux de sortie produits soit par quatre filtres pyramidaux bidimensionnels soit par un filtre pyramidal bidimensionnel d'ordre trois en utilisant quatre matrices d'échantillons de signal $P^{3x3}_{j-1,j-1}$, $P^{3x3}_{i-1,j+1}$, $P^{3x3}_{i+1,j-1}$, $P^{3x3}_{i+1,j+1}$, comprennent des signaux de sortie soumis à filtre pyramidal produits par une pluralité de filtres pyramidaux unidimensionnels.

**17.** Support de stockage selon la revendication 16, dans lequel lesdits filtres pyramidaux unidimensionnels comprennent une séquence d'unités opérationnelles sans multiplicateur en cascade évolutives, chacune desdites unités opérationnelles pouvant produire un flux d'échantillons de signal de sortie soumis à filtre pyramidal d'ordre différent.

**18.** Système de traitement d'image comprenant :

une unité de traitement d'image pour filtrer des images couleur scannées ;
ladite unité de traitement d'image comprenant au moins une architecture de filtre pyramidal bidimensionnelle ;
ladite au moins une architecture de filtre pyramidal bidimensionnelle comprenant :

une architecture de filtre pyramidal bidimensionnelle d'un ordre 2N-1, dans laquelle N est un entier positif supérieur à deux ;
ladite architecture de filtre pyramidal bidimensionnelle d'ordre 2N-1, en fonctionnement, pouvant produire, sur des cycles d'horloge respectifs, au moins ce qui suit :

des signaux de sortie soumis à filtre pyramidal correspondant aux signaux de sortie produits par deux filtres pyramidaux unidimensionnels d'ordre 2N-1 ; et
des signaux de sortie soumis à filtre pyramidal correspondant aux signaux de sortie produits soit par quatre filtres pyramidaux bidimensionnels soit par un filtre pyramidal bidimensionnel d'ordre [2(N-1)-1] en utilisant des matrices d'échantillons de signal d'ordre [2(N-1)-1] ;

dans lequel les signaux de sortie respectifs dans ladite architecture de filtre pyramidal bidimensionnelle sont ajoutés sur des cycles d'horloge respectifs de ladite architecture de filtre pyramidal bidimensionnelle.

**19.** Système selon la revendication 18, dans lequel N est trois ;
des signaux de sortie soumis à filtre pyramidal correspondant aux signaux de sortie produits soit par quatre filtres pyramidaux bidimensionnels soit par un filtre pyramidal bidimensionnel d'ordre [2(N-1)-1] en utilisant des matrices d'échantillons de signal d'ordre [2(N-1)-1] comprennent des signaux de sortie produits par quatre filtres pyramidaux bidimensionnels d'ordre trois.

**20.** Système selon la revendication 18, dans lequel N est trois ; et

dans lequel les signaux de sortie soumis à filtre pyramidal correspondant aux signaux de sortie produits soit par quatre filtres pyramidaux bidimensionnels soit par un filtre pyramidal bidimensionnel d'ordre trois en utilisant quatre matrices d'échantillons de signal $P^{3x3}_{i-1,j-1}$, $P^{3x3}_{i-1,j+1}$, $P^{3x3}_{i+1,j-1}$, $P^{3x3}_{i+1,j+1}$, comprennent des signaux de sortie soumis à filtre pyramidal produits par une pluralité de filtres pyramidaux unidimensionnels.

**21.** Système selon la revendication 20, dans lequel lesdits filtres pyramidaux unidimensionnels comprennent une séquence d'unités opérationnelles sans multiplicateur en cascade évolutives, chacune desdites unités opérationnelles pouvant produire un flux d'échantillons de signal de sortie soumis à filtre pyramidal d'ordre différent.

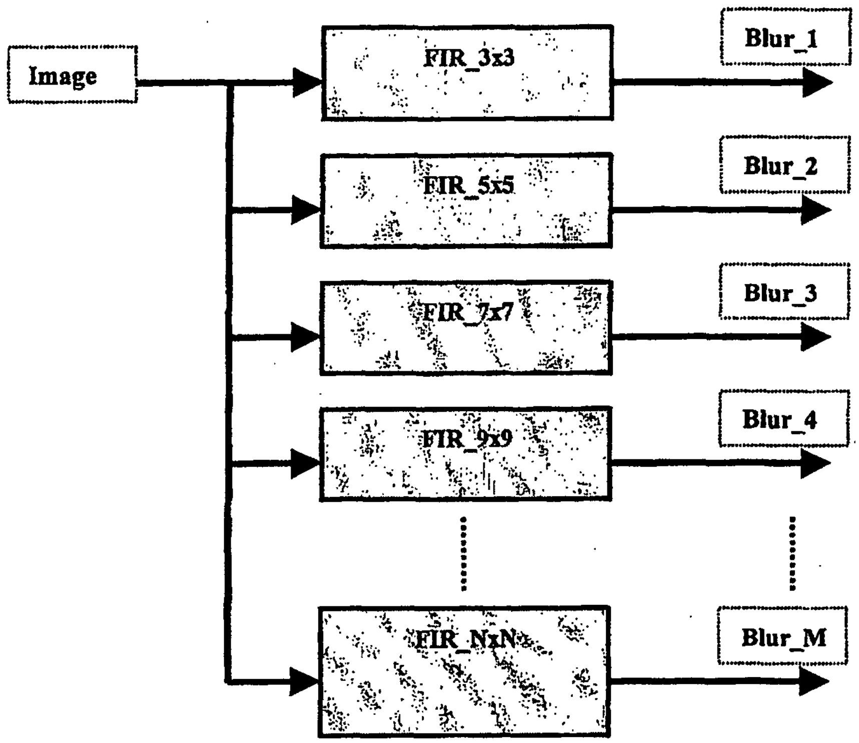
Image
FIR_3x3
FIR_5x5
FIR_7x7
FIR_9x9
FIR_NxN
Blur_1
Blur_2
Blur_3
Blur_4
Blur_M

FIG. 1

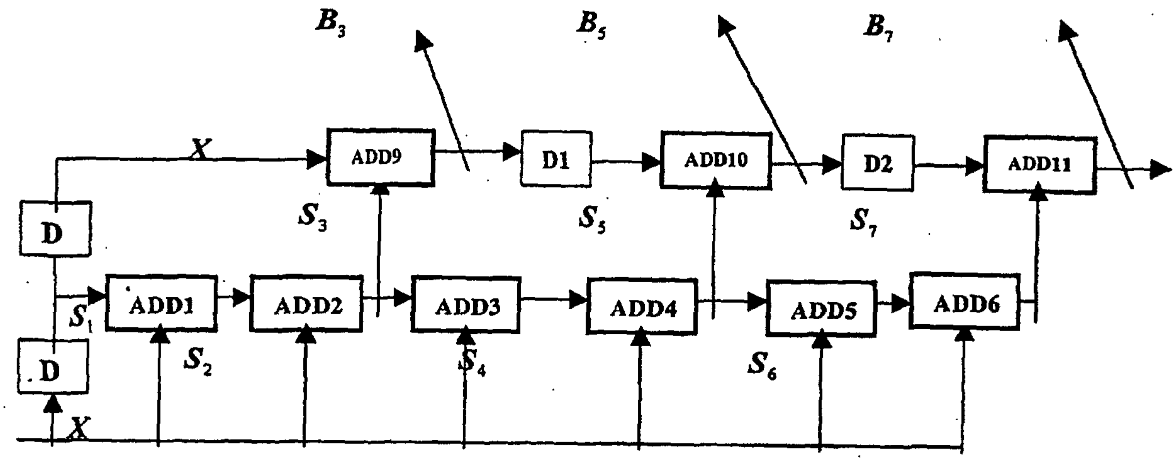

B3
B5
B7
X
ADD9
D1
ADD10
D2
ADD11
S3
S5
S7
D
ADD1
ADD2
ADD3
ADD4
ADD5
ADD6
S1
D
S2
S4
S6
X


FIG. 2

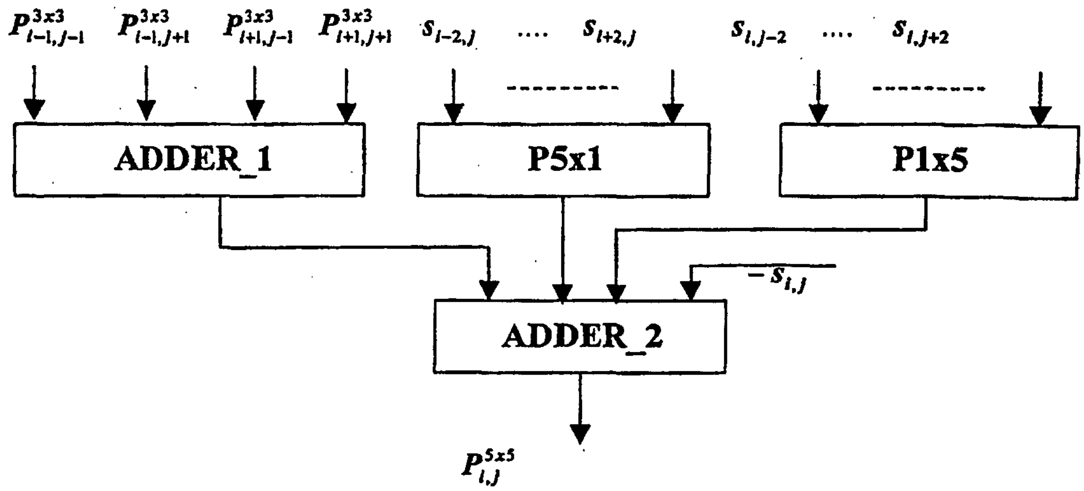
$P^{3x3}_{i-1,j-1}$
$P^{3x3}_{i-1,j+1}$
$P^{3x3}_{i+1,j-1}$
$P^{3x3}_{i+1,j+1}$
$s_{i-2,j}$ .... $s_{i+2,j}$
$s_{i,j-2}$ .... $s_{i,j+2}$
ADDER_1
P5x1
P1x5
$-s_{i,j}$
ADDER_2
$P^{5x5}_{i,j}$

FIG. 3

FIG. 4

$$P^{k\times k}=\begin{bmatrix} P_{0,0}^{k\times k} & P_{0,1}^{k\times k} & . & \cdots & . & . & P_{0,N-1}^{k\times k} \\ P_{1,0}^{k\times k} & P_{1,1}^{k\times k} & . & . & . & . & P_{1,N-1}^{k\times k} \\ . & . & . & . & . & . & . \\ \vdots & . & . & P_{i,j}^{k\times k} & . & . & \vdots \\ . & . & . & . & . & . & . \\ . & . & . & . & . & . & . \\ P_{M-1,0}^{k\times k} & P_{M-1,1}^{k\times k} & . & \cdots & . & . & P_{M-1,N-1}^{k\times k} \end{bmatrix}$$

FIG. 5

$$S=\begin{bmatrix} s_{0,0} & s_{0,1} & . & \cdots & . & . & s_{0,N-1} \\ s_{1,0} & . & . & . & . & . & s_{1,N-1} \\ . & . & s_{i-1,j-1} & s_{i-1,j} & s_{i-1,j+1} & . & . \\ \vdots & . & s_{i,j-1} & s_{i,j} & s_{i,j+1} & . & \vdots \\ . & . & s_{i+1,j-1} & s_{i+1,j} & s_{i+1,j+1} & . & . \\ . & . & . & . & . & . & . \\ s_{M-1,0} & s_{M-1,1} & . & \cdots & & . & s_{M-1,N-1} \end{bmatrix}$$

$$F_{kxk} = \begin{bmatrix} 1 \\ 2 \\ 3 \\ \vdots \\ \frac{k-1}{2} \\ \vdots \\ 3 \\ 2 \\ 1 \end{bmatrix} * \begin{bmatrix} 1 & 2 & 3 & \cdots & \frac{k-1}{2} & 4 & 3 & 2 & 1 \end{bmatrix}$$

$$= \begin{bmatrix} 1 & 2 & 3 & \cdots & \frac{k-1}{2} & \cdots & 3 & 2 & 1 \\ 2 & 4 & 6 & \cdots & \frac{2(k-1)}{2} & \cdots & 6 & 4 & 2 \\ 3 & 6 & 9 & \cdots & \frac{3(k-1)}{2} & \cdots & 9 & 6 & 3 \\ \vdots & \vdots & \vdots & \vdots & \vdots & \vdots & \vdots & \vdots & \vdots \\ \frac{k-1}{2} & \frac{2(k-1)}{2} & \frac{3(k-1)}{2} & \cdots & \frac{(k-1)*(k-1)}{4} & \cdots & \frac{3(k-1)}{2} & \frac{2(k-1)}{2} & \frac{k-1}{2} \\ \vdots & \vdots & \vdots & \vdots & \vdots & \vdots & \vdots & \vdots & \vdots \\ 3 & 6 & 9 & \cdots & \frac{3(k-1)}{2} & \cdots & 9 & 6 & 3 \\ 2 & 4 & 6 & \cdots & \frac{2(k-1)}{2} & \cdots & 6 & 4 & 2 \\ 1 & 2 & 3 & \cdots & \frac{k-1}{2} & \cdots & 3 & 2 & 1 \end{bmatrix}$$

FIG. 6

$$F_{9x9} = \begin{bmatrix} 1 \\ 2 \\ 3 \\ 4 \\ 5 \\ 4 \\ 3 \\ 2 \\ 1 \end{bmatrix} * \begin{bmatrix} 1 & 2 & 3 & 4 & 5 & 4 & 3 & 2 & 1 \end{bmatrix} = \begin{bmatrix} 1 & 2 & 3 & 4 & 5 & 4 & 3 & 2 & 1 \\ 2 & 4 & 6 & 8 & 10 & 8 & 6 & 4 & 2 \\ 3 & 6 & 9 & 12 & 15 & 12 & 9 & 6 & 3 \\ 4 & 8 & 12 & 16 & 20 & 16 & 12 & 8 & 4 \\ 5 & 10 & 15 & 20 & 25 & 20 & 15 & 10 & 5 \\ 4 & 8 & 12 & 16 & 20 & 16 & 12 & 8 & 4 \\ 3 & 6 & 9 & 12 & 15 & 12 & 9 & 6 & 3 \\ 2 & 4 & 6 & 8 & 10 & 8 & 6 & 4 & 2 \\ 1 & 2 & 3 & 4 & 5 & 4 & 3 & 2 & 1 \end{bmatrix}$$

FIG. 7

$$P^{1xk} = \begin{bmatrix} P^{1xk}_{0,0} & P^{1xk}_{0,1} & . & \cdots & . & . & P^{1xk}_{0,N-1} \\ P^{1xk}_{1,0} & P^{1xk}_{1,1} & . & . & . & . & P^{1xk}_{1,N-1} \\ . & . & . & . & . & . & . \\ \vdots & . & . & P^{1xk}_{i,j} & . & . & \vdots \\ . & . & . & . & . & . & . \\ . & . & . & . & . & . & . \\ P^{1xk}_{M-1,0} & P^{1xk}_{M-1,1} & . & \cdots & . & . & P^{1xk}_{M-1,N-1} \end{bmatrix}$$

FIG. 8

$$P^{kx1} = \begin{bmatrix} P^{kx1}_{0,0} & P^{kx1}_{0,1} & . & \cdots & . & . & P^{kx1}_{0,N-1} \\ P^{kx1}_{1,0} & P^{kx1}_{1,1} & . & . & . & . & P^{kx1}_{1,N-1} \\ . & . & . & . & . & . & . \\ \vdots & . & . & P^{kx1}_{i,j} & . & . & \vdots \\ . & . & . & . & . & . & . \\ . & . & . & . & . & . & . \\ P^{kx1}_{M-1,0} & P^{kx1}_{M-1,1} & . & \cdots & . & . & P^{kx1}_{M-1,N-1} \end{bmatrix}$$

FIG. 9